(19) Europäisches Patentamt
European Patent Office
Office européen des brevets

(11) **EP 2 595 276 A1**

(12) **EUROPEAN PATENT APPLICATION**
published in accordance with Art. 153(4) EPC

(43) Date of publication:
**22.05.2013 Bulletin 2013/21**

(51) Int Cl.:
**H02J 7/10** (2006.01)    **H01M 10/44** (2006.01)
**H01M 10/48** (2006.01)

(21) Application number: **11806578.8**

(22) Date of filing: **09.06.2011**

(86) International application number:
**PCT/JP2011/063270**

(87) International publication number:
**WO 2012/008247 (19.01.2012 Gazette 2012/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.07.2010 JP 2010159442**

(71) Applicant: **Panasonic Corporation**
**Osaka 571-8501 (JP)**

(72) Inventor: **TAKADA, Kosaku**
**Osaka 540-6207 (JP)**

(74) Representative: **Grünecker, Kinkeldey,**
**Stockmair & Schwanhäusser**
**Leopoldstrasse 4**
**80802 München (DE)**

(54) **SECONDARY BATTERY CHARGING METHOD AND CHARGING APPARATUS**

(57)    In a method for charging a secondary battery (21), for determining, by a detection of -ΔV which is observed when a battery voltage is decreased by ΔV from a peak voltage, that the secondary battery (21) is fully charged, an invalid time for invalidating a detection of the peak voltage and the detection of -ΔV is set; the invalid time is calculated by dividing a current integrated quantity of a rapid charge current caused to flow in the secondary battery (21) by an average charge current quantity at a time of the rapid charge; and determining that the secondary battery (21) is fully charged, by the detection of -ΔV which is observed when the battery voltage of the secondary battery is decreased by ΔV from the peak voltage after a lapse of the invalid time from a start of the charging of the secondary battery (21).

FIG. 5

EP 2 595 276 A1

## Description

### Technical Field

The present invention relates to a secondary battery charging method and charging apparatus. Especially, the present invention relates to a charging method and charging apparatus for a secondary battery which determines that the secondary battery is fully charged by a detection of -$\Delta$V which is obtained when a battery voltage is decreased by $\Delta$V from a peak voltage at the time of charging of the secondary battery.

### Background Art

It is necessary to appropriately charge a secondary battery. This is because of a fear that, in the case of a poor charge state, a device cannot be sufficiently operated due to poor battery capacity, while in the case of an overcharge, an abnormal heat or performance deterioration of the battery may be caused.

Especially, in the case of an ordinary secondary battery, even merely repeating proper charge-discharge cycles gradually decreases the chargeable battery capacity, thus deteriorating the capacity. Otherwise, a charge environmental temperature, an overdischarge condition, an overcharge condition, and the like are responsible for accelerating the deterioration of the capacity of the secondary battery.

Under a control of a timer control circuit or the like, trying to charge the capacity-deteriorated secondary battery with a battery capacity equivalent to that charged to a secondary battery in an initial state causes the overcharge, thus an abnormal heat and the like is likely to be caused. Thus, it was necessary to implement measures, other than the timer control circuit and the like, for preventing the overcharge by determining whether or not the secondary battery has reached the full charge.

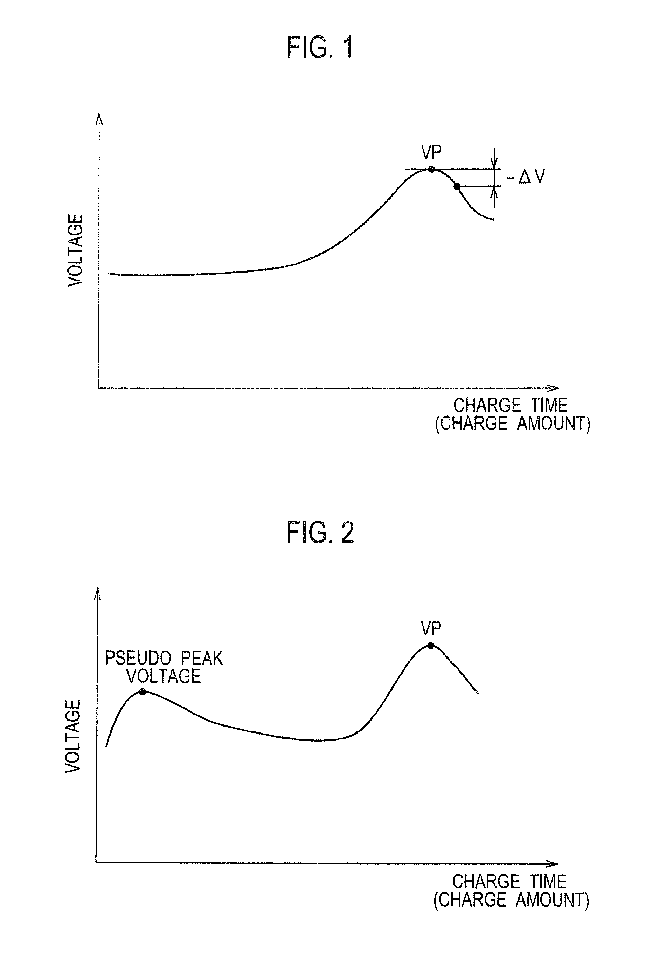

Then, as an appropriate charging method for implementing a rapid charge by a relatively large charge current, one called -$\Delta$V control method is widely known in general. The -$\Delta$V control method uses such a point as that the charge voltage characteristic of the secondary battery has a peak voltage VP near the full charge, as illustrated in Fig. 1. That is, the -$\Delta$V control method is such a technology as to detect and memorize the peak voltage VP, and to stop the charge operation based on a determination that the secondary battery is fully charged when the battery voltage is dropped by a predetermined voltage $\Delta$V after reaching the peak voltage VP (hereinafter referred to as "-AV control"). Further, after the charge current is shut off, such a trickle charge current as not to reach the overcharge is caused to flow.

On the other hand, in the case of a secondary battery such as a nickel-metal hydride battery, nickel-cadmium battery, or the like which is in a non-charge state due to a long time left-uncontrolled condition (hereinafter referred to as "long time stored battery"), inactivation is caused within the battery during the storage. Charging the long time stored battery that is in an inactive state causes the above-described peak voltage VP at the completion of the charging, while, as the case may be, causing, before the completion of the charging, a peak voltage (pseudo-peak voltage) different from the above peak voltage VP, as illustrated in Fig. 2.

When the long time stored battery which may cause the pseudo-peak voltage is charged, determining, by the -$\Delta$V control method, whether or not the secondary battery is fully charged had such a fear as that the pseudo-peak voltage might be erroneously detected as the peak voltage VP that is obtained after the charge completion. In such a case, there was a fear that a voltage drop immediately after the detection of the pseudo-peak voltage would serve to determine that the secondary battery is fully charged to thereby end the charging. As a result, the secondary battery is likely to have an insufficient charge, thus causing a shortage of the battery capacity.

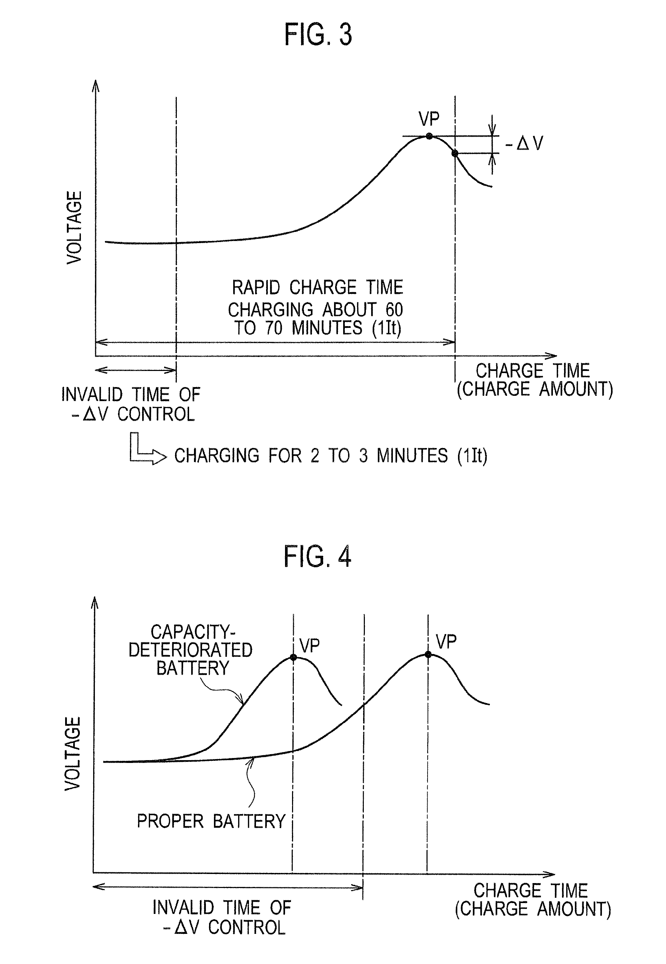

For preventing the insufficient charge due to the above erroneous detection, for example, one described in PTL 1 is known. PTL 1 describes such a technology as that the detection of the peak voltage and subsequent -$\Delta$V is not implemented for a predetermined time after the charge started. For example, in the case of a 1It charging (a rapid charge bringing about a full charge state in an hour), as illustrated in Fig. 3, an invalid time of the -$\Delta$V control was set such that the detection of the peak voltage and -$\Delta$V is not implemented for two to three minutes after the charge started.

### Citation List

### Patent Literature

PTL1: JP 2007-252086 A

### Summary of Invention

However, for example, in the case of the 1It charging, the voltage drop, as the case may be, continues for over 3 minutes depending on the inactivation state of the secondary battery, and it is also assumed that the voltage drop may continue as long as for 30 minutes. In these cases, it was feared that the setting of the invalid time in the above -$\Delta V$ control might cause such a failure that the erroneous detection cannot be prevented.

On the other hand, an unreasonably longer setting of the invalid time in the -$\Delta V$ control caused such a fear, in the case of the charging of the secondary battery having the deteriorated capacity, as that the -$\Delta V$ control might be started after the full charge, depending on the deterioration state of the secondary battery, as illustrated in Fig. 4. In such a case, accurately detecting the peak voltage VP and subsequent -$\Delta V$ is of difficulty, thus causing a fear of the overcharge.

In view of the above, the present invention has been made. It is an object of the present invention to provide a method and an apparatus of charging a secondary battery which optimizes the invalid time in the -$\Delta V$ control and are capable of satisfying prevention of the overcharge as well as securement of a requisite minimum battery capacity.

For accomplishing the above object, according to a first aspect of the present invention, there is provided a method of charging a secondary battery for determining, in charging the secondary battery, by a detection of -$\Delta V$ which is observed when a battery voltage is decreased by $\Delta V$ from a peak voltage, that the secondary battery is fully charged, the method including: calculating an invalid time as a value (Srap/Irap) obtained by dividing a current integrated quantity of a rapid charge current caused to flow in the secondary battery by an average charge current quantity at a time of the rapid charge; setting the invalid time for invalidating a detection of the peak voltage and the detection of -$\Delta V$; and determining that the secondary battery is fully charged, by the detection of -$\Delta V$ observed when the battery voltage of the secondary battery is decreased by $\Delta V$ from the peak voltage after an elapse of the invalid time from a start of the charging of the secondary battery.

Further, according to a second aspect of the present invention, there is provided a charging apparatus of a secondary battery for determining, in charging the secondary battery, by a detection of -$\Delta V$ which is observed when a battery voltage of the secondary battery is decreased by $\Delta V$ from a peak voltage, that the secondary battery is fully charged, the charging apparatus including: a memory for memorizing an invalid time calculated by dividing a current integrated quantity of a rapid charge current caused to flow in the secondary battery by an average charge current quantity at a time of the rapid charge; a meter for measuring a lapse of time of the charging after a start of the charging of the secondary battery; and a controller for determining, that the secondary battery is fully charged, by the detection of -$\Delta V$ which is observed when the battery voltage of the secondary battery is decreased by $\Delta V$ from the peak voltage after the invalid time is measured by the meter from a start of the charging of the secondary battery.

With the charging method according to the first aspect of the present invention as well as the charging apparatus according to the second aspect of the present invention, calculating the invalid time by dividing the current integrated quantity of the rapid charge current caused to flow in the secondary battery by the average charge current at the time of the rapid charge can optimize the invalid time. As a result, validating the -$\Delta V$ control after a lapse of the invalid time from the start of the charging can secure the requisite minimum battery capacity and prevent the overcharge.

## Brief Description of Drawings

[Fig. 1] Fig. 1 illustrates a charge time relative to a battery voltage in the charging of a secondary battery.

[Fig. 2] Fig. 2 illustrates the charge time relative to the battery voltage in the charging of the secondary battery in an inactive state.

[Fig. 3] Fig. 3 illustrates setting of an invalid time in a -$\Delta V$ control, in the charge time relative to the battery voltage in the charging of the secondary battery.

[Fig. 4] Fig. 4 illustrates the charge time relative to the battery voltage of each of a proper secondary battery and a secondary battery with a deteriorated capacity.

[Fig. 5] Fig. 5 illustrates a structure of a charging apparatus according to a first embodiment.

[Fig. 6] Fig. 6 illustrates the charge time relative to the battery voltage according to the first embodiment.

## Description of Embodiments

Hereinafter, an embodiment will be explained, referring to drawings.

(First Embodiment)

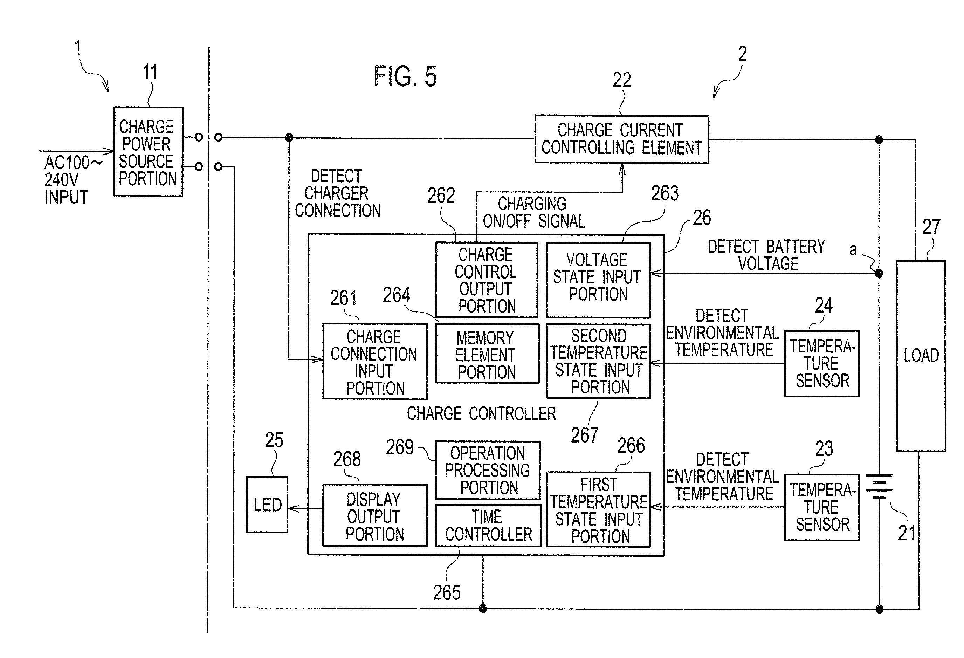

A charging apparatus according to a first embodiment illustrated in Fig. 5 includes a charger side block 1 and a main body side block 2.

The charger side block 1 includes a power supply 11 and configured to be attachable to the main body side block 2. The power supply 11 has a structure as a DC power supply which supplies a constant voltage and a constant current to the main body side block 2 by inputting a commercial AC power source of about 100 V to 240 V. It is so configured that, when the power supply 11 is unable to supply a predetermined maximum current to the main body side block 2, the power supply 11 supplies a current less than or equal to the predetermined maximum current.

The main body side block 2 has a structure of a charging apparatus. The main body side block 2 provides the invalid time in the -ΔV control and determines whether or not a secondary battery is fully charged. The charging apparatus of the main body side block 2 includes a secondary battery 21, a charge current controlling device 22, a first temperature sensor 23, a second temperature sensor 24, a display 25, a charge controller 26, and a load 27.

The secondary battery 21 is a secondary battery such as a nickel-metal hydride battery, a nickel-cadmium battery, or the like, and is charged with the current supplied from the power supply 11. The secondary battery 21 serves as a power source of the load 27 such as a DC motor. Though the secondary battery 21 in Fig. 5 is exemplified, for example, by two batteries connected in series, but the number of batteries is not restricted.

The charge current controlling device 22 is connected between the power supply 11 and the secondary battery 21, and controls the charge current supplied to the secondary battery 21. The charge current controlling device 22 includes a switching element and the like. By a pulse width modulation (PWM) control for making an on/off control of the switching element based on charge on/off signals, the charge current controlling device 22 controls and adjusts the charge current supplied to the secondary battery 21.

The first temperature sensor 23 detects a temperature of the secondary battery 21, and outputs the detected temperature as a battery temperature signal to the charge controller 26.

The second temperature sensor 24 detects a room temperature, and outputs the detected room temperrature as a room temperature signal to the charge controller 26.

The display 25 includes, for example, light-emitting diodes (LEDs), and displays a charge state of the secondary battery 21 by, for example, the number of LEDs lighted.

The charge controller 26 functions as a control center for controlling the operation of the charging apparatus, and is realized by a microcomputer and the like (equipped with hardware resources such as CPU and memory) which are necessary for controlling various operational processes based on a program. Implementing the process program by the CPU (processing unit 269) of the microcomputer included in the charge controller 26 realizes the various functions (for charging the secondary battery 21) including the -ΔV control.

The charge controller 26 includes a charge connection input portion 261, a charge control output portion 262, a voltage state input portion 263, a memory element 264, a timer controller 265, a first temperature state input portion 266, a second temperature state input portion 267, a display output portion 268, and the processing unit 269.

Based on a connection signal inputted to the charge connection input portion 261, the charge controller 26 determines whether or not the charge power source portion 11 is connected to the body side block 2. After confirming that the charge power source portion 11 is connected to the body side block 2, the charge controller 26 is brought into a state being capable of controlling the charging operation of the secondary battery 21.

The charge controller 26 supplies the charge on/off signal to the charge current controlling device 22 via the charge control output portion 262. Based on the charge on/off signal, the charge controller 26 implements the on/off control of the charge current controlling device 22, to thereby implement the PWM control at an arbitrary duty ratio. By this operation, the charge controller 26 generates and supplies to the secondary battery 21 a constant current of a desired average current (such as a rapid charge current and a trickle charge current).

After a lapse of an invalid time in the -ΔV control preset after the start of the charging of the secondary battery 21, the charge controller 26 detects the battery voltage of the secondary battery 21 at a measurement point "a" as needed, and then inputs the detected battery voltage via the voltage state input portion 263. As set forth below, the invalid time of the -ΔV control is calculated in advance, and then is memorized and prepared in the memory element 264 (memory). Further, by using a later-described calculation method, the invalid time of the -ΔV control may be calculated in the charge controller 26 by inputting various variables necessary for the calculation and corresponding to the specification of the secondary battery 21.

The invalid time of the -ΔV control is measured by the timer controller 265 (meter) after the start of charging of the secondary battery 21. The charge controller 26 detects the peak voltage VP of the battery voltage and a voltage drop ΔV from the peak voltage VP (detection of -ΔV). Detecting -ΔV after the detection of the peak voltage VP, the charge controller 26 determines that the secondary battery 21 is fully charged, to thereby stop the charging operation or implement a supplementary charge.

When it is determined, based on the battery temperature signal inputted via the first temperature state input portion 266 or the room temperature signal inputted via the second temperature state input portion 267, that at least one of the room temperature and the battery temperature deviates from a range preset in the specifications and the like, the charge controller 26 stops the charging operation from a security point of view.

The charge controller 26 outputs to the display 25 the control signal which controls the lighting of the LEDs of the display 25 via the display output portion 268. Based on the program memorized and prepared in advance in the memory element 264, the charge controller 26 implements various operation processes by the processing unit 269 including the CPU, to thereby control the charging operation.

Next, procedures for calculating the optimum value of the invalid time in the -ΔV control in the above charging apparatus will be explained.

[Setting of necessary capacity]

First, with the secondary battery brought into an end-of-life state due to the progressing deterioration of the battery capacity, for example, in a state where the battery capacity at the time of the full charge is 50% to 70% that in a proper state or with the secondary battery brought into an inactive state due to being leftuncontrolled for a long time for one year or more, an operation time of the device which time is preset based on the specification and the like and is spent by one rated charge is defined as Tdis (h). Further, an average consumption current in the operation of the device is defined as Idis (mA). The average consumption current Idis differs with types of the load 27 used for the device.

Generally, with respect to the secondary battery, the actual capacity that can be taken out is smaller than the capacity stored in the battery, thus leading to the following equation: dischargeable capacity/stored capacity = discharge efficiency. This discharge efficiency is defined as y (a constant in the range of 0 to 1.00). Using each of the parameters, a requisite minimum battery capacity (discharge capacity) Ccap (mAh) required for the secondary battery in the end-of-life state or left-uncontrolled state for a long time is calculated by the following expression (1).

(Expression 1)

$$Ccap = Tdis \times Idis / y \cdots (1)$$

[Charge efficiency of battery]

In the secondary battery, there exists a charge efficiency x (= charge capacity/charge current integrated quantity; a constant in the range of 0 to 1.00) at the time of the charging, like at the time of the discharging. Thus, the current integrated quantity Is (mAh) necessary for charging the capacity portion equivalent to the requisite minimum battery capacity Ccap is calculated by the following expression (2).

(Expression 2)

$$Is = Ccap / x \cdots (2)$$

[Capacity equivalent to deep discharge region (capacity from device operation stop voltage up to 0 V)]

For preventing the deterioration attributable to the overdischarge of the secondary battery, the device with the secondary battery as a power source, generally, has such an operation as to stop operation when the battery voltage drops to be less than or equal to a predetermined voltage, and it is so controlled to prevent a low voltage state (deep discharge state) less than or equal to an undercut voltage at which this operation stops.

On the other hand, when the device with the secondary battery as the power source is leftuncontrolled for a long time, without being charged, after the device stopped operation , the battery voltage (battery capacity) further continues to decrease due to a minor consumption current, a natural discharge and the like in the device, finally resulting in a deep discharge state in which the capacity is completely discharged.

Where, a capacity held by the battery from the undercut voltage to the deep discharge state is defined as Cdep (mAh). Then, a battery capacity Ccd (mAh) necessary for satisfying the above Tdis (h) in the deep discharge state of the secondary battery is calculated by the following expression (3).

(Expression 3)

$$Ccd = (Ccap / x) + Cdep \cdots (3)$$

[Calculation of optimum value of invalid time in -ΔV control]

When the secondary battery is, for example, a nickel-metal hydride battery or a nickel-cadmium battery, generally, the charging operation of the secondary battery is divided into a rapid charging operation and a trickle charging operation which is supplementarily operated after the rapid charging operation. Where, the average charge current at the time of the rapid charge is defined as Irap (mA), and the trickle charge current at the time of the trickle charge is defined as Itrc (mA). Except restrictions associated with the battery performance, the average charge current Irap (mA) and the trickle charge current Itrc (mA) can be arbitrarily set by the designer.

In the case where the secondary battery such as a nickel-metal hydride battery and a nickel-cadmium battery is brought into the inactive state due to a long time left-uncontrolled state, it is general to implement the trickle charge for a predetermined time after the ordinary rapid charge so as to bring the secondary battery into a reactivated state.

Thus, in the charging operation of the secondary battery, it is so configured that the battery capacity stored by the charging operations of both the rapid charge and the trickle charge satisfies the above operation time Tdis of the device spent by the one rated charge.

A trickle charge recommended time that is recommended for implementing the trickle charge is defined as Ttrc (h), a current integrated quantity Srap (mAh) of the charge current supplied, at the time of the rapid charge, to the secondary battery in the inactive state is calculated by the following expression (4) by using each of the above variables.

(Expression 4)

$$ Srap = (Ccap\,/\,x) + Cdep - (Itrc \times Ttrc) \cdots (4) $$

Thus, for satisfying the operation time Tdis of the device spent by the one rated charge, a minimum charge time Ttrmin (h) at the time of the rapid charge is calculated by the following expression (5) from the current integrated quantity Srap calculated by the expression (4) and the average charge current Irap at the time of the rapid charge.

(Expression 5)

$$ Ttrmin = Srap/Irap \cdots (5) $$

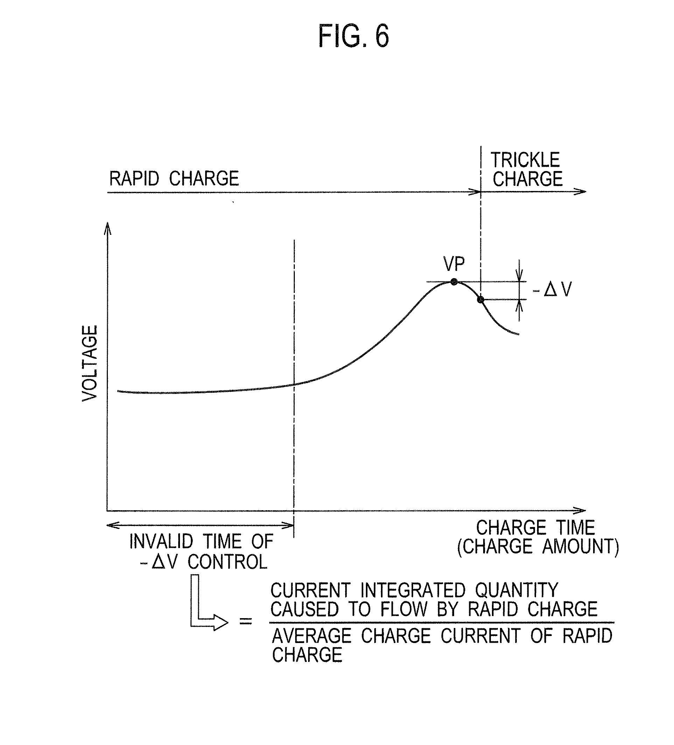

When charging the secondary battery in the inactive state, setting the charge time to the minimum charge time Ttrmin calculated by the expression (5) can secure the requisite minimum battery capacity Ccap. Then, as illustrated in Fig. 6, the invalid time in the $-\Delta V$ control is so set that the detection of the peak voltage and the detection of $-\Delta V$ become invalid during the minimum charge time Ttrmin after the charge start. This enables to secure the minimum requisite battery capacity even in such a case as, after the invalid time set to the above minimum charge time Ttrmin, the peak voltage of the battery voltage is detected, then $-\Delta V$ is erroneously detected and then the charging operation is ended. Further, the $-\Delta V$ control is validated after the invalid time, thus enabling to prevent the overcharge.

The second battery's capacity finally assumed in the case of the progressed deterioration is estimated from complicated factors such as characteristic of the battery, variation of the battery and the usage environment. Therefore, to what extent the end-of-life battery capacity should be set is to be determined depending on the manufacture or type of the secondary battery.

Where, a capacity of the secondary battery having the progressed deterioration is defined as Clag, the requisite minimum battery capacity Ccap can optimize the invalid time of the $-\Delta V$ control by the above expression (5) when Ccap $\leq$ Clag is satisfied.

On the other hand, in the case of the secondary battery satisfying Ccap > Clag, the $-\Delta V$ control is validated after the full charge, thus causing such a fear as that the above setting of the invalid time would cause a risk for an erroneous detection. Thus, in this case, it is desirable to determine that the secondary battery is fully charged, by another charge control method of the $-\Delta V$ control, for example, a control method by variation of the secondary battery's temperature increase per unit time.

As set forth above, according to the embodiment, the invalid time for invalidating the $-\Delta V$ control can be appropriately set. This enables to perform an appropriate charge control of both a secondary battery having progressed capacity deterioration and a secondary battery left unused for a long time. That is, the heat generation attributable to the overcharge can be prevented, the decrease of the usage time or the number of uses of the device can be suppressed, and the minimum requisite battery capacity necessary for operating the device for a predetermined time can be secured.

Further, with the structure of the apparatus likely to cause an erroneous detection of $-\Delta V$ due to noise and the like, and even in the case of charging the proper secondary battery neither having capacity deterioration nor being left uncontrolled for a long time, the minimum requisite battery capacity necessary for operating the device for a predetermined time can be secured.

**Industrial Applicability**

The charging apparatus according to the embodiment is applicable to small electric devices such as an electric razor, an electric hair clipper, an electric epilator, and an electric toothbrush. The charging apparatus according to the embodiment charges a secondary battery provided for the above small electric devices such as an electric razor.

**Claims**

1. A method of charging a secondary battery for determining, in charging the secondary battery, by a detection of -$\Delta V$ which is observed when a battery voltage is decreased by $\Delta V$ from a peak voltage, that the secondary battery is fully charged, the method comprising:

    calculating an invalid time as a value obtained by dividing a current integrated quantity of a rapid charge current caused to flow in the secondary battery by an average charge current quantity at a time of the rapid charge; setting the invalid time for invalidating a detection of the peak voltage and the detection of -$\Delta V$; and determining, that the secondary battery is fully charged, by the detection of -$\Delta V$ which is observed when the battery voltage of the secondary battery is decreased by $\Delta V$ from the peak voltage after a lapse of the invalid time from a start of the charging of the secondary battery.

2. The method of charging the secondary battery according to claim 1, further comprising:

    calculating the current integrated quantity of the rapid charge current, which is caused to flow in the secondary battery, based on a battery capacity required for the secondary battery in one of a capacity deterioration state and a long time left-uncontrolled state, a charge efficiency at a time of the charging, a battery capacity equivalent to a deep discharge region, and a trickle charge current quantity and a trickle charge time at a time of a trickle charge.

3. A charging apparatus of a secondary battery for determining, in charging a secondary battery, by a detection of -$\Delta V$ which is observed when a battery voltage of the secondary battery is decreased by $\Delta V$ from a peak voltage, that the secondary battery is fully charged, the charging apparatus comprising:

    a memory for memorizing an invalid time calculated by dividing a current integrated quantity of a rapid charge current caused to flow in the secondary battery by an average charge current quantity at a time of the rapid charge; a meter for measuring a lapse of time of the charging after a start of the charging of the secondary battery; and a controller for determining that the secondary battery is fully charged, by the detection of -$\Delta V$ which is observed when the battery voltage of the secondary battery is decreased by $\Delta V$ from the peak voltage after the invalid time is measured by the meter from the start of the charging of the secondary battery.

4. The charging apparatus of the secondary battery according to claim 3, wherein
    the current integrated quantity of the rapid charge current caused to flow in the secondary battery is calculated based on a battery capacity required for the secondary battery in one of a capacity deterioration state and a long time left-uncontrolled state, a charge efficiency at a time of the charging, a battery capacity equivalent to a deep discharge region, and a trickle charge current quantity and a trickle charge time at a time of a trickle charge.

## FIG. 1

## FIG. 2

## FIG. 3

VP

−ΔV

VOLTAGE

RAPID CHARGE TIME
CHARGING ABOUT 60
TO 70 MINUTES (1It)

CHARGE TIME
(CHARGE AMOUNT)

INVALID TIME OF
−ΔV CONTROL

⌐⟶ CHARGING FOR 2 TO 3 MINUTES (1It)

## FIG. 4

CAPACITY-
DETERIORATED
BATTERY

VP

VP

VOLTAGE

PROPER BATTERY

INVALID TIME OF
−ΔV CONTROL

CHARGE TIME
(CHARGE AMOUNT)

# FIG. 5

EP 2 595 276 A1

# FIG. 6

RAPID CHARGE

TRICKLE CHARGE

VOLTAGE

VP

$-\Delta V$

CHARGE TIME
(CHARGE AMOUNT)

INVALID TIME OF
$-\Delta V$ CONTROL

$$= \frac{\text{CURRENT INTEGRATED QUANTITY}}{\text{AVERAGE CHARGE CURRENT OF RAPID}}$$
CAUSED TO FLOW BY RAPID CHARGE

CHARGE

## INTERNATIONAL SEARCH REPORT

| International application No. |
|---|
| PCT/JP2011/063270 |

**A. CLASSIFICATION OF SUBJECT MATTER**
*H02J7/10*(2006.01)i, *H01M10/44*(2006.01)i, *H01M10/48*(2006.01)i

According to International Patent Classification (IPC) or to both national classification and IPC

**B. FIELDS SEARCHED**

Minimum documentation searched (classification system followed by classification symbols)
H02J7/10, H01M10/44, H01M10/48

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2008-086106 A  (Matsushita Electric Industrial Co., Ltd.), 10 April 2008 (10.04.2008), entire text; all drawings (Family: none) | 1-4 |
| A | JP 06-327167 A  (Makita Corp.), 25 November 1994 (25.11.1994), entire text; all drawings & US 5467005 A           & DE 4326960 A & DE 4326960 A1 | 1-4 |
| A | JP 02-219424 A  (Sanyo Electric Co., Ltd.), 03 September 1990 (03.09.1990), entire text; all drawings (Family: none) | 1-4 |

☐ Further documents are listed in the continuation of Box C.    ☐ See patent family annex.

| | |
|---|---|
| \*   Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| 02 September, 2011 (02.09.11) | 13 September, 2011 (13.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007252086 A